# EUROPEAN PATENT APPLICATION

(11) **EP 1 302 974 A2**
(43) Date of publication of application: **16.04.2003**
(21) Application number: 02022700.5
(22) Date of filing: 10.10.2002
(51) Int. Cl.: H01L 21/00

(54) **Chip alignment and placement apparatus for integrated circuit, MEMS, photonic or other devices**

(30) Priority: 11.10.2001 US 328504 P
(71) Applicant: Westvaco Corporation, Alfred H Nissan Technical Center, Laurel, Maryland 20723 (US)
(72) Inventor: Spedden, Richard H., Clarksville, MD 21029 (US); Bauer, Donald G., Laurel, MD 20723 (US); Rasband, Paul B., Frederick, MD 21701 (US); Collins, Richard A., Ellicott City, MD 21042 (US); Bryden, Michelle D., Ellicott City, MD 21042 (US)
(74) Representative: Hepworth, John Malcolm

(57) **Abstract**

Devices for manipulating, receiving and dispensing diced semiconductor materials, in which the semiconductor material is diced to provide partially connected dice in linear aggregations.

## Description

This invention relates to efficient methods and devices for handling small semiconductor chip devices having an average width of approximately 1 mm or less. The method provides for more precise and efficient placement of integrated circuit devices on a substrate during the manufacture of radio frequency identification (RFID) and other electronics systems.

Several well-known processes including photolithography and etching, among other means, have been used to fabricate integrated circuit (IC) devices. By such means, small IC devices, hereinafter referred to as "chips," may be produced from a single wafer that has been sliced from an ingot of a suitable semiconductor material. The semiconductor material is typically silicon or a silicon alloy such as silicon-germanium. In such processes, after a silicon ingot has been produced, for example, it is sliced into wafers, which are each polished on either side. One face, typically the top face, of each wafer is then processed using one of several known semiconductor fabrication methods. Next, to facilitate handling of the wafer, this top face is adhered to a support, for example an adhesive film, before the wafer is thinned from the bottom surface by grinding or other known methods to a thickness of less than about 10 mils. Another adhesive backing film layer, for example a vinyl film, is then affixed to the ground bottom surface, after which the top surface support material is removed and the wafer is then cut or scored. The wafer is then separated into individual devices ("diced") by sawing or etching, according to a rectilinear grid pattern on the wafer surface, to form individual chips, each of which is adhered on one side to the backing film layer, and maintained in spatial relationship to each other by means of their common attachment to this film. For RFID applications, the resulting chips are usually quite small in size, on the order of about 1 mm or less. Because of their diminutive size, orderly manipulation and placement of the devices after they are separated is difficult. The presence of the adhesive backing film maintains orderly positioning of the chips, and also allows ease of transport and manipulation during subsequent processing operations.

The discoid configuration of chips bound together by the adhesive film is then placed in an apparatus that removes and places the individual chips onto a final support substrate for forming the desired semiconductor device. Alternatively, the chips may be transferred from the wafer-film to an intermediate adhesive carrier tape from which they are then removed and placed on the ultimate substrate in preparation for building a semiconductor device. This "pick and place" method is usually accomplished by apparatus that use robotic arms to separate and remove each individual chip from the diced wafer and adhere it onto the desired substrate. In this regard, the final placement of the chip must be precise to allow it to be properly located for subsequent connection to circuitry on the substrate. This method of removing and placing individual chips is slow, because the chips are very small and fragile, and thus require careful handling. This difficulty in handling and the resulting processing inefficiency is addressed by the various embodiments of the invention described herein.

The invention comprises a means for efficient processing of semiconductor chips that minimizes the well-recognized handling difficulties inherent to conventional pick-and-place methodology. The method provides and maintains a linear alignment of chips from the point of formation to the point of placement on the end-use substrate. A desirable feature of the invention is that the chips are separated by the cutting step into linear aggregations positioned end-to-end as sticks, from which individual chips may be systematically separated and placed on an end-use substrate. In this regard, the manner of operation is akin to that of a stapler dispensing individual staples into the desired substrate material. The invention further encompasses apparatus for manipulating and placing the chips on the end-use substrate.

In one embodiment, therefore, the invention comprises a method of processing semiconductor chips for use in integrated circuit, MEMS or photonic device manufacture comprising:
a) scoring or partly sawing a wafer of semiconductor material in at least one dimension to provide at least one parting line;
b) breaking the wafer by further sawing or other means in a dimension perpendicular to the at least one parting line to form one or more linear aggregations of individual chips joined together on at least one side thereof, each such linear chip aggregation being separated by one or more severed edges of the individual chips;
c) aligning the one or more linear chip aggregations with reception sites on a receiving substrate; and
d) dispensing individual chips from the one or more linear chip aggregations onto the reception sites by severing a single chip from each linear chip aggregation and contacting it with the surface of the receiving substrate while simultaneously preserving its linear orientation and controlling its alignment on the surface of the substrate.

In another aspect, the invention is a method of manufacturing an integrated circuit device comprising:
a) preparing a receiving substrate;
b) separating a wafer of semiconductor material into one or more linear chip aggregations;
c) aligning the one or more linear chip aggregations with reception sites on a receiving substrate;
d) severing a single chip from the one or more linear chip aggregations and contacting it with the reception site while simultaneously preserving the linear orientation and controlling the alignment of said chip; and
e) disposing one or more devices selected from antennae, contacts, circuits or electrodes in direct or proximate relationship to the chip on the receiving substrate.

In another aspect, the invention is an apparatus for dispensing semiconductor chips comprising:
a) one or more chambers for receiving and holding one or more linear chip aggregations; and
b) a stapler apparatus that dispenses individual chips from the one or more linearly aligned aggregations within the one or more chambers onto reception sites on a substrate.

According to the invention, a selective scoring and cutting process may be used to separate a semiconductor wafer into linear series of individual chips, designated herein as "linear chip aggregations," instead of being diced immediately into individual chips, as is done conventionally. Suitable semiconductor materials include silicon or silicon alloys, or other materials known to have desirable conductive properties. The actual manufacture of the wafer and the subsequent sawing process used to partition or "dice" it into individual chips is well known in the art. In a typical process, the top face of a wafer cut from a silicon ingot is glued to a support. This fixes the wafer to secure it during further processing, and also protects the top face from damage. The bottom surface of the wafer is then ground or otherwise thinned to reduce the wafer thickness to about less than 10 mils, ideally about 5-10 mils. The ground bottom surface is then attached to an adhesive film that acts as a transport or carrier film during the remaining processing steps. One such film is NITTO™ tape, which is a vinyl film manufactured by Nitto Denko. The adhesive is then removed from the top face of the wafer and it is separated or diced using a conventional cutting method.

The wafer may be cut using a method of appropriate precision, e.g. mechanical, laser, sonic, thermal or chemical means. In the process of the invention, however, the routine means of cutting is modified to provide incomplete penetration through to the bottom of the wafer along one axis, e.g. the "Y" axis thereof, while complete perforation is achieved along the perpendicular axis, i.e. the "X" axis. This standard nomenclature with respect to the directional axes is used herein only to describe the relative orientation of the cutting direction and is not otherwise intended to limit the scope of this disclosure. According to this procedure, therefore, linear chip aggregations remain joined together by virtue of the incomplete perforations and/or the tape, for example in the plane of the Y-axis, but are completely separable from the wafer along the X-axis. Thus, the adhesive film layer, and, if desired, a thin bridge of the semiconductor material remain uncut, so holding the chips in adjacent alignment. If the latent parting line is a score line, nearly the entire thickness of the semiconductor material may remain uncut. If multiple chip sticks are spliced end-to-end, using an adhesive material, the stiffness and the shear strength of the adhesive material should match that of the semiconductor material to ensure clean separation when a single chip is severed.

Where the chips are held together by tape, the tape is desirably of a material that is sufficiently tacky to allow firm attachment of the chips during processing but easy removal at the next stages of processing. The adhesive tape also desirably permits clean handling with minimal or no ionic impurities, can be manipulated without tearing and also is preferably heat tolerant to withstand high processing temperatures. A medium tack electronic processing tape is preferred. A suitable adhesive film is NITTO, which is an electronic processing tape available in high, medium or low adhesion varieties. Other known means of adhesively attaching chips together on a cut or scored wafer, including the use of UV-deactivatable tape, may also be used.

The resulting chips typically are of a width on the order of about 1 mm or less, which is comparable to the size of conventionally available chips. In this respect, a typical circular silicon wafer having a diameter of about 6" may be separated into approximately 150 linear chip aggregations of from 1 inch or more in length, preferably from about 1 inch to about 6 inches in length, each carrying a linearly aligned arrangement of 25 or more chips. The chips in this linear alignment are attached to each other via the uncut silicon along the X-axis, and optionally also by a common adhesive region such as an adhesive tape or film, or both. Diced chips that are held together only by an adhesive film or tape could, however, also be used in the apparatus or methods of the invention.

Once the linear chip aggregations are formed, each may be individually loaded into a stapler apparatus configured to systematically dispense and place individual chips in sequence on a targeted reception site. This apparatus may be of various configurations to accept, transport, store or sequentially dispense single or multiple linear chip aggregations. This apparatus is comprised of one or more chambers for accommodating one or more linear chip aggregations; and a dispensing device for placement and release of individual chips. In various embodiments, the apparatus may include multiple chambers formed as a magazine, and a dispensing device positioned in communicable relation to the magazine. In one of the simplest embodiments, however, the stapler apparatus is a single unit having a single-chamber magazine into which linear chip aggregations are loaded and from which these materials are dispensed.

The linear chip aggregation is pulled or pushed through the magazine while maintaining a constant interval between chips. To move the linear chip aggregations through the magazine, one or more wheels, belts, or bars may be used. If there are saw kerfs, i.e. grooves made by the cutting tool, between chips, some or all wheels, belts or bars may include teeth to engage the open spaces between chips. In this regard, the teeth should preferably be small enough to fit in the saw kerf. As an additional option, a vacuum may be applied through the wheels or bars to help hold the linear chip aggregations in the desired alignment. If a film membrane is attached to the linear chip aggregation during handling, it may desirably be wound around suitably proportioned wheels and onto a take-up reel to be discarded.

To move the linear chip aggregations into the chambers of the stapler apparatus and to dispense chips onto the substrate, the apparatus may include a first tamping means engageable with the loading end of the apparatus and a second tamping means engageable with the dispensing end thereof. Preferably, the tamping means are spring-tensioned and/or pressure-operated elements. In the simple version of the stapler apparatus having a single chamber for receiving and dispensing chips, the first tamping means is engaged, at the loading end, with one end of a linear chip aggregation, and at the other with a hammer or other pneumatic device that applies pressure to the tamping means to move the linear chip aggregation in a horizontal plane into the chamber and toward the dispensing end. At each reception site pressure is applied to the spring element of the tamping means, which pushes the linear chip aggregation to a previously calibrated stop position such that a single chip is pushed out of the dispensing orifice. At this point, the extended chip is attached to the remainder of the linear chip aggregation either by a residual vein of uncut semiconductor material or by the uncut film of adhesive tape, or both. This residual vein is formed by a score line imposed between adjacent chips. In the methods herein disclosed, the linear chip aggregation may be used with the score line facing upward or downward in relation to the dispensing end.

To sever the chip, a second tamping means having a mode of operation similar to the first applies pressure to one face of the chip in a plane perpendicular to the plane of movement of the linear chip aggregation. The amount of pressure and the tamping distance is pre-calibrated to provide precise contact with the surface of the substrate and sufficient pressure to ensure separation of the chip and deposition onto the surface of the substrate without shifting. In order that the chip not flip or shift at or after this point, some means of adhesive attachment to the substrate must be provided, such as an adhesive film already placed on the substrate, preferably an electrically conductive adhesive, and most preferably an anisotropic conductive adhesive. Alternately, an adhesive tape may be placed over the chip during the placement operation to hold the chip to the substrate. It may additionally be necessary during chip placement to momentarily stop the substrate movement to align the chip with the reception site, or to oscillate the dispensing means so that during the placement operation, the apparatus moves at the same speed as the substrate.

Another embodiment of the stapler apparatus comprises a sliding or rotating member, typically in the form of a shutter device at the dispensing end of the mechanism. This shutter device acts to stop the linear chip aggregation at the precise position for dispensing, and it also serves to contain the individual chip being separated from the linear chip aggregation, so that when separated, the individual chip does not drop from the stapler until the shutter has moved to a position that allows the chip to be dispensed. The shutter device may incorporate means to assist in the breaking of the individual chip away from the linear aggregation of chips. This breaking means can include a sliding or rotating motion of the shutter or part of the shutter, with this motion occurring in precise synchronization with the other parts of the dispensing mechanism.

Another embodiment of the stapler comprises a tape applied along the length of the linear aggregation within the dispensing device, the tape having areas that are locally conductive, adhesive, or both, to help attach the chip to a substrate both electrically and physically. The adhesive film layer, if present on the linear chip aggregation, may be removed before the linear chip aggregation is loaded into the magazine. Alternatively, if the adhesive film is to remain attached to the linear chip aggregation, an anisotropic conductive film (ACF) material may be used. This material allows transmission of electrical current, and would thus provide an electrical connection to an antenna device if, for example, the chip were to be used in a radio frequency identification system. As yet another alternative, an insulating tape may be used as the adhesive film layer, particularly where a capacitive coupling will be used. Such tape would provide desirable dielectric properties and would be durable enough to withstand the mechanical manipulation and high temperatures involved with processing. Preferably, the tape is attached to the top face of the chip, preferably atop any contacts that may be attached to the chip face. If tape is also used on the bottom face of the chip, it will usually be useful only for physical attachment but not for electrically connecting the chip to the substrate.

The substrate may be a flexible or non-flexible substrate, which can be moved in relation to the stapler apparatus to provide new reception sites for alignment with the dispensing orifices, or, alternatively, the substrate may remain immobilized while the stapler is mechanically maneuvered into position over the reception sites. In either of these embodiments, the stapler may be suitably calibrated to move prescribed distances in a single plane or in multiple planes to sequentially contact one or more reception sites. The unit may also be used in conjunction with sensors on the conveyor equipment that moves the substrate. These sensors detect the presence of target areas and synchronize the dispensing action. In one such means, sensors on the conveyor equipment communicate with a detector mounted on the apparatus to provide precise targeted alignment.

In alternative embodiments of the stapler apparatus, the magazine and dispensing device may be separate elements that communicably engage with each other to provide transfer of linear chip aggregations from the cutting step to the point of dispensing on the target. In such embodiments, a flat magazine or a rotary magazine, or other suitable configuration that allows simultaneous loading of multiple linear chip aggregations may be used. Regardless of the method of moving or separating the chips from the linear chip aggregation, the up/down orientation of the linear chip aggregation must be such that any electrical contacts on the chip are positioned properly; that is, the contacts will be facing either up or down after the chip is placed on the substrate. If the linear chip aggregation is not backed by an adhesive film layer, the up/down orientation may be achieved merely by turning the linear chip aggregation chip-face downward as it is placed in the magazine. However, if the linear chip aggregation is backed by a film layer while in the magazine, one or more extra preparation steps may be required to ensure proper orientation, and extra equipment may be required to remove any disposable adhesive film material that is removed before or after the chip is affixed to the substrate.

As mentioned previously, the magazine may accommodate one or more linear chip aggregations. For example, multiple linear chip aggregations may be stacked vertically or horizontally at the back of the magazine and sequentially aligned for dispensing. To dispense the chips, the stack of linear chip aggregations may be placed at the "loading" end of the magazine, and the linear chip aggregation closest to the magazine pushed into the magazine by a tamping device such as a reciprocating plunger to allow loading of another linear chip aggregation into the magazine. One potential drawback of manipulating the linear chip aggregations in this bundled fashion is breakage or damage caused by abrasion between the linear chip aggregations. In this regard, a lubricant, such as water or other suitable fluid lubricant is applied over the surfaces of the linear chip aggregations after cutting to reduce friction. Alternatively, plastic or metal interposer strips may be inserted between linear chip aggregations, or a compressed air flow directed between the linear chip aggregations to keep them separated by a cushion of air.

The one or more magazines may then be loaded into the apparatus to communicate with the dispensing device, which is positioned in fixed relationship above the substrate material. The positioning is preferably at as close a distance to the substrate as possible to reduce the chance of shifts in alignment or compression breakage during placement. The apparatus may then be used to dispense the individual chips without the need for complex robotics elements. The chips are placed on top of or adjacent to elements already on the substrate to build various electronic devices. For example, an antenna loop or electrodes may have been applied to the substrate by means such as die-stamping, printing conductive inks, or other known means. Preferably, such elements are attached to the substrate surface before the chip is attached. Other electronic elements such as wire bonds may be placed in direct contact with or proximate to the chip on the substrate after the chip is attached.

A typical production process for making RFID tags involves creating a series of antennas on a substrate web by using one of several methods known in the art for producing conductive circuitry traces on flexible substrates. The substrate web would then be run through a processing system to attach the RFID chips. Such a system would typically include stations for attaching anisotropic conductive film onto a portion of the antenna, a pick-and-place station to apply the chip, and a curing station to set the adhesive. Additional stations may be provided including a testing station to verify correct operation of the tag, and optionally to program it, and perhaps a slitting or cutting station to produce narrow rolls of tags, or individual tags. If it is necessary for the substrate web to pause at certain stations, then buffer stations may be included that incorporate festoons or other devices to provide for taking up slack in the web.

Various exemplary only embodiments of the invention are hereinafter disclosed with reference to the accompanying drawings, in which:-
Figure 1 is a planar representation of a circular semiconductor wafer scored with a rectilinear grid pattern to delineate linear chip aggregations;
Figure 2 is a planar representation of the semiconductor wafer of Figure 1, showing the removal of one or more linear chip aggregations;
Figure 2A is a transverse sectional representation of a chip that may be dispensed according to the invention;
Figure 2B is a transverse sectional representation of a linear chip aggregation in which the individual chips are connected by a bridge of semiconductor material and an adhesive tape layer;
Figure 2C is a transverse sectional representation of a linear chip aggregation in which the individual chips are connected by a bridge of semiconductor material without the adhesive tape layer;
Figures 3 and 3A are isometric views of flat magazine staplers for dispensing semiconductor chips onto substrates of varying orientation;
Figure 4 shows an alternative embodiment of a stapler apparatus comprised of multiple flat magazine staplers arranged in tandem;
Figure 5a is an exploded isometric view of a rotary magazine stapler apparatus for receiving, transporting and dispensing linear chip aggregations onto a substrate;
Figures 5b through 5e are transverse sections of the outer sleeve, optional inner sleeve and cylinder components of various rotary magazines according to the invention;
Figure 6A is an exploded isometric view of a rotary magazine equipped with a grooved inner sleeve and a slotted outer sleeve for receiving and dispensing the linear chip aggregations;
Figure 6B provides an exploded isometric view of a rotary magazine having a grooved inner sleeve equipped with vacuum ports for accommodating linear chip aggregations and an outer sleeve with slots for insertion and release of linear chip aggregations;
Figure 7 is an isometric view of a dispensing device attached to a rotary magazine;
Figure 8A is a planar representation of a dispensing device for use with either a flat or rotary magazine in the process of the invention. Figures 8B and 8C are transverse views of a vacuum device, which is an optional element of the dispensing device. Figure 8D is a planar representation of another dispensing device incorporating a shutter mechanism. Figures 8E through 8P are transverse views showing the operation of this dispensing device;
Figure 9 is a schematic outlining a process of dispensing individual chips or other semiconductor devices according to the process of the invention;
Figure 10 is a planar view of a dispensing device incorporating a tape mechanism;
Figure 11 is an isometric view of the tape dispensing mechanism;
Figure 12 is a transverse view of the tape in relation to a chip that will be attached to the tape; and
Figure 13 is an isometric view of a tape interposer, with an attached chip, being attached to the poles of an antenna.

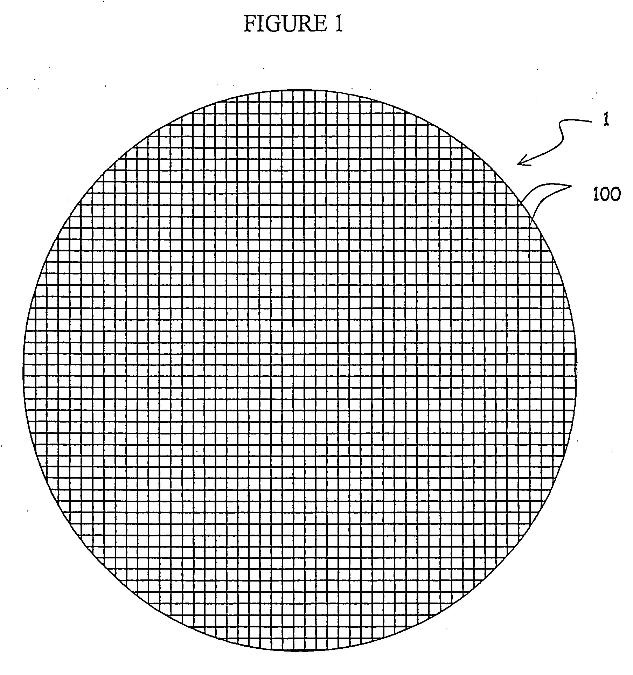

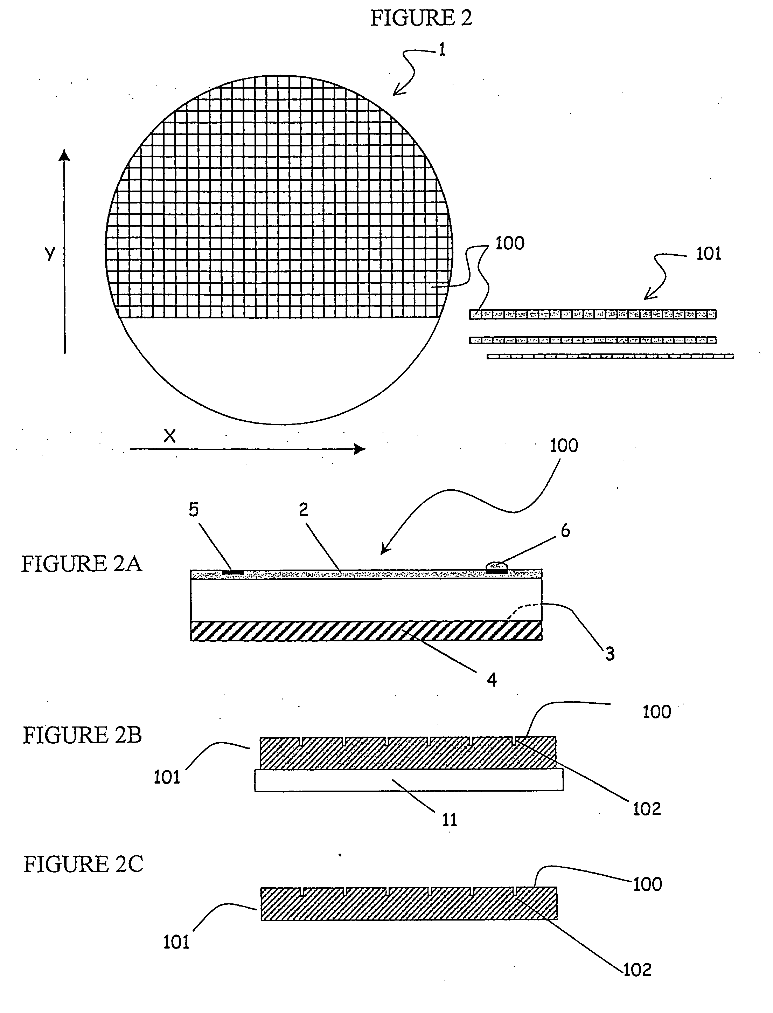

According to the accompanying figures, a standard semiconductor wafer 1 as shown in Figure 1 may be broken by cutting, sawing or other dicing methods into linear chip aggregations 101, each composed of individual semiconductor chips 100. According to the invention, the wafer 1 is sawed to achieve partial perforation along one axis and complete penetration along the perpendicular axis. In this manner, multiple linear chip aggregations 101 may be formed from the wafer 1, as shown in Figure 2. Typically, the linear chip aggregations 101 may comprise up to about 150 individual chips aligned end to end in stick fashion, each chip 100 being approximately 1 mm or less in width. The shape, whether square or rectangular, and size of the individual chips may vary depending on the cutting dimensions applied to the wafer 1. In a preferred embodiment, however, the chips 100 are formed according to approximately square dimensions.

As shown in Figure 2A, each individual chip 100 deposited using the process of the present invention typically includes micro-circuitry 2 deposited by conventional means (e.g. photolithography, vapor deposition or other known means) on its surface. Chip 100 may further have deposited thereon one or more electrical contacts 5 and, optionally, one or more bumped contacts 6 for improving electrical receptivity on the top face of the chip. Preferably, the bottom face 3 of the wafer 1 is thinned before sawing by grinding or other conventional means, after which an adhesive carrier film 4 is applied to the ground surface to maintain alignment and proximity of the chips on the wafer during dicing, transport and in subsequent applications.

Figure 2B is a cross section of a linear chip aggregation 101 in which the dicing is achieved by partial cutting that leaves semiconductor bridges 102 between individual chips 100. Furthermore, an adhesive film 11 is adhered to the bottom surface of the linear chip aggregation 101. Alternatively, the linear chip aggregation 101 may be formed with semiconductor bridges 102 in the absence of a supporting adhesive layer, as shown in Figure 2C.

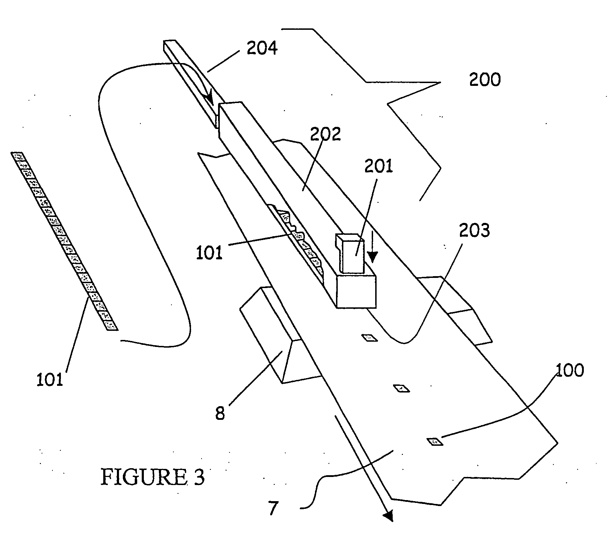

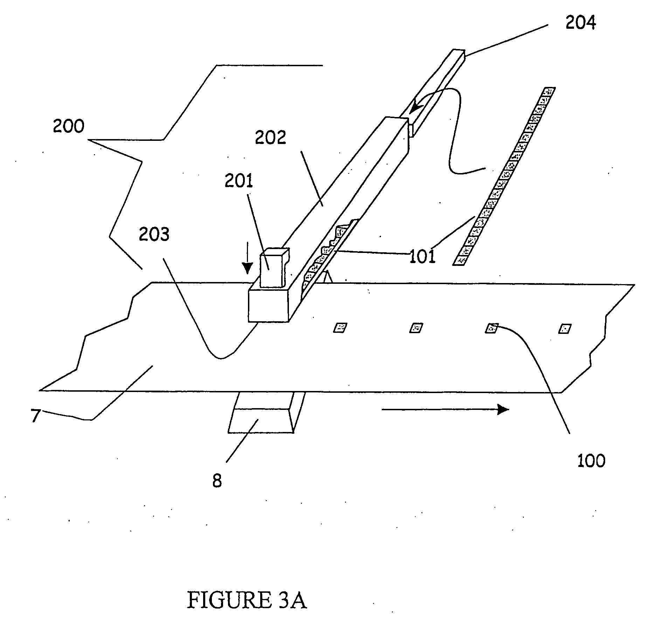

Figure 3 provides an isometric external view of a flat magazine stapler apparatus 200 for receiving linear chip aggregations 101. Stapler 200 is comprised of a flat magazine 202, a dispensing opening 203, a first tamping means 204 for moving the one or more linear chip aggregations through the flat magazine 202, and a second tamping means 201. The stapler 200 is positioned in fixed or movable relationship to a substrate 7 and aligned at the shortest possible distance from the surface of the substrate 7 to allow deposition of individual chips 100 from the dispensing opening 203. The substrate 7 is preferably a flexible substrate made of a material such as paper, paperboard, plastic, or laminates of various flexible conductive or non-conductive materials. It is supported or moved in parallel or transverse orientation to the dispensing opening 203, for example over one or more supports 8. According to the embodiment of Figure 3, as the substrate 7 is moved over the support 8, individual chips 100 are deposited through the dispensing opening 203 onto substrate 7. In this regard, as the substrate 7 is advanced, a linear chip aggregation 101 is advanced through the flat magazine 202 a sufficient distance to expose and align the outer edge of the chip aggregation 101 with a second tamping means 201 and the surface of the substrate 7. The exposed chip 100 is then severed by application of perpendicular force from the tamping means 201. Optionally, the edge of the flat magazine 202 directly beneath the second tamping means 201 may be equipped with a cutting edge (not shown) to sever the chip 100 in concert with the force applied by the tamping means 201. The precise placement of chip 100 is facilitated by maintaining close proximity of the dispensing opening 203 with the surface of the substrate 7, and by eliminating flipping or random movement of the chip 100 during its severance and deposition. Generally, random movement and flipping may be minimized by pre-applying an adhesive coating or film on the surface of substrate, or, alternatively, by incorporating a releasable vacuum source into the tamping means 201 to ensure controlled delivery onto the target surface. As shown in Figure 3A, the substrate 7 may be oriented to move in a direction perpendicular, or at any other angle, to the dispensing orientation of the stapler 200. The substrate 7 may be momentarily halted during chip placement, or the stapler 200 and support 8 may be reciprocated along the direction of the moving substrate 7 so that the substrate 7, stapler 200 and support 8 are moving at the same speed at the time of placement.

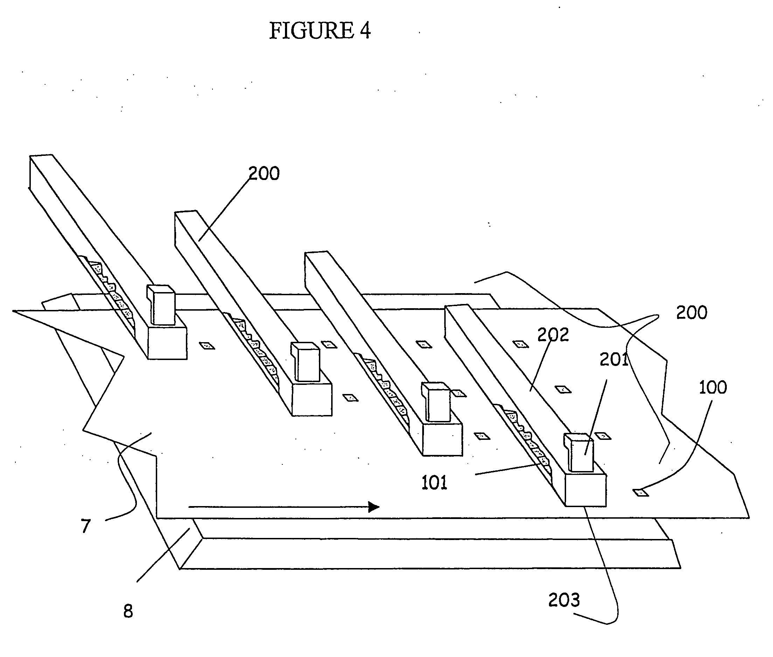

Multiple flat magazine staplers may be arranged in tandem to provide synchronized and efficient placement of individual die, as shown in Figure 4.

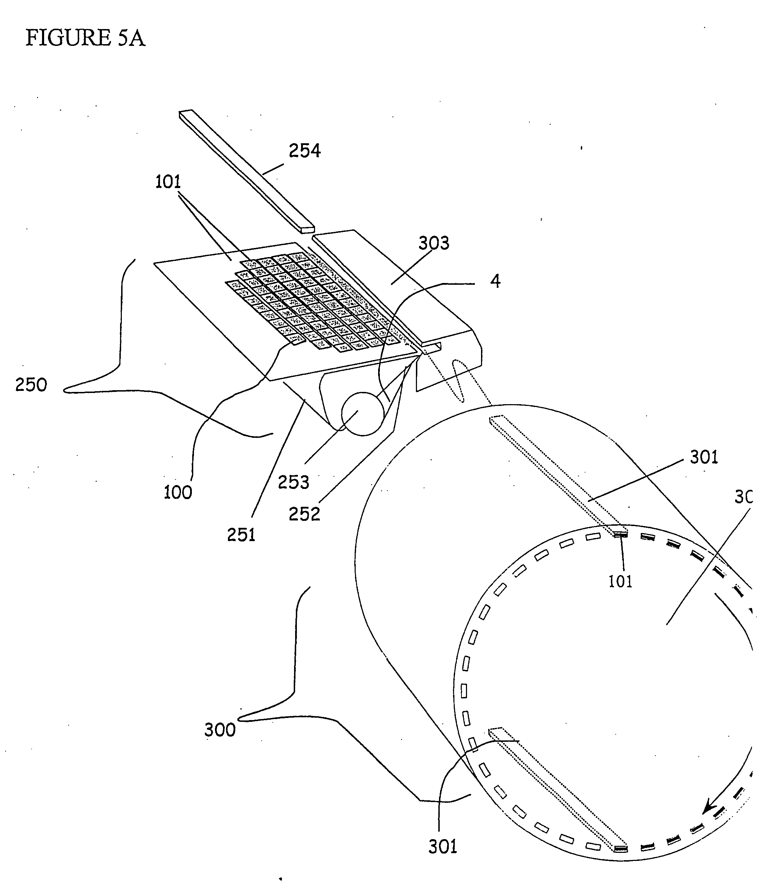

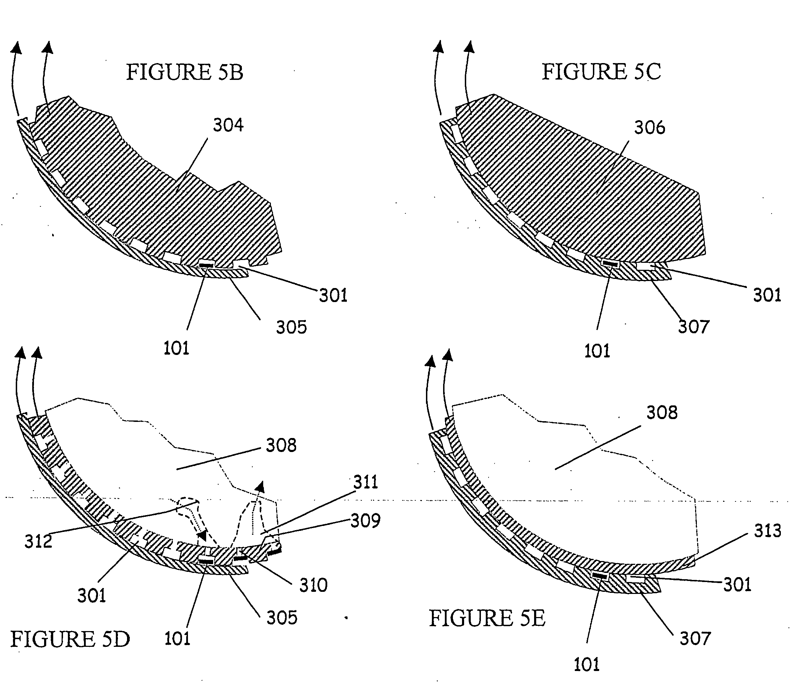

The linear chip alignments are individually separated from the wafer and transferred to the magazine. The loading device used at this step in the process may be used in cooperation with the aforementioned flat magazine or with other magazines, such as the rotary magazines described herein. One such loading device 250 is exemplified in the embodiment of Figure 5A, which further depicts a rotary magazine 300. Loading device 250 comprises an angled support 251 having an edge 252 of narrowed dimension in relation to the rest of support 251. Backing adhesive film 4 is wound around a rotating means 253, which, by periodically turning to pre-set stops, advances linear chip aggregation 101 into the receiving slot 303. Linear chip aggregations 101 are mounted on support 251 and then loaded into individual chambers 301 in the magazine 300. It should be understood that as an alternative, the wafer may be previously separated into linear aggregations, which can then be serially loaded directly into receiving slot 303. Linear chip aggregation 101 is moved over support 251, passed into receiving slot 303, and is moved into chamber 301 by lateral pressure applied by tamping means 254. An example of a suitable loading device that may be used in the process of this invention is described in U.S. Patent No. 4,590,667, herein incorporated by reference. The apparatus described therein provides separation of individual rows of completely separated semiconductor dice to allow vacuum pickup and placement of individual die. The loading device of the present invention is modified to permit simultaneous pickup and transfer of multiple dice in the form of the linear chip alignments previously described herein. The loading device may be used in cooperation with, or as an integrally formed part of any of the magazines described herein.

To protect the electronic circuitry on the face of the chips 100, the multiple chambers 301 may be lined with or coated with low-friction materials such as Teflon®. Such low-friction materials may be used in any other parts of the invention where the linear chip aggregations 101 may move in sliding motion along confining surfaces.

Rotary magazine 300, as shown in Figure 5A, includes a core cylinder 304 equipped with conventional turning means (not shown) and multiple chambers 301 around the periphery of cylinder 304. Each chamber 301 is sized to accommodate at least one linear chip aggregation 101. The rotation of the cylinder 304 is preferably synchronized to align an empty chamber 301 with receiving slot 303 as tamping force is applied from tamping means 254, thus facilitating transfer of the linear chip aggregation 101 into the chamber 301, after which the cylinder 304 is again rotated and the process repeated. The rotary magazine 300 can thus be loaded offline in this manner and later employed in a latter process, or it may be disposed for continuous loading by the process described above and off-loaded in an inline process.

Figures 5B, 5C, 5D and 5E are transverse sections of various configurations of the chambers 301 in relation to the core cylinder of rotary magazine 300. According to Figure 5B, smooth outer sleeve 305 is attached to and cooperates in rotation with a toothed cylinder 304, which has indentations on the outer surface thereof that form chambers 301. Alternatively, according to Figure 5C, a smooth core cylinder 306 may be disposed in proximate, rotational relation to a grooved outer sleeve 307, which includes indentations on the inner surface thereof that form chambers 301.

Figure 5D shows a smooth outer sleeve 305 rotationally operable in relation to a stationary, non-rotating core cylinder 308. A toothed inner sleeve 309 with grooves forming chambers 301 is disposed between outer sleeve 305 and the stationary core cylinder 308. In operation, inner sleeve 309 and outer sleeve 305 are rotated. In an optional modification, outer sleeve 305 is kept stationary. Inner sleeve 309 includes ports 310 through which vacuum may be applied through vacuum passages 311 within core cylinder 308 to hold linear chip aggregations 101 in chambers 301. Vacuum pressure is applied to ports 310 during pickup and transport only. Linear chip aggregation 101 is released after chamber 301 has rotated to the desired position, at which time contact between ports 310 and vacuum passages 311 is lost and, optionally, contact with pressure passages 312 is engaged. Application of positive pressure through the passages 312 releases the hold on the linear chip aggregation 101 and optionally, may be used to help move the linear chip aggregation 101 from the chamber 301. The rotary magazine of Figure 5E is composed of a grooved outer sleeve 307, and a smooth inner sleeve 313, which both rotate around a stationary core cylinder 308. In a further embodiment, the vacuum and pressure system of Figure 5D can also be implemented in the magazine of Figure 5E. It should be understood that with the embodiments shown in Figures 5B-5E, only the toothed or grooved member must rotate. Rotation of other members is optional, although it may be preferred in some cases to minimize friction on the linear chip aggregation 101. However, in Figure 5D, the inner core cylinder must be non-rotating in order to preserve the sequencing of the vacuum and pressure ports 310.

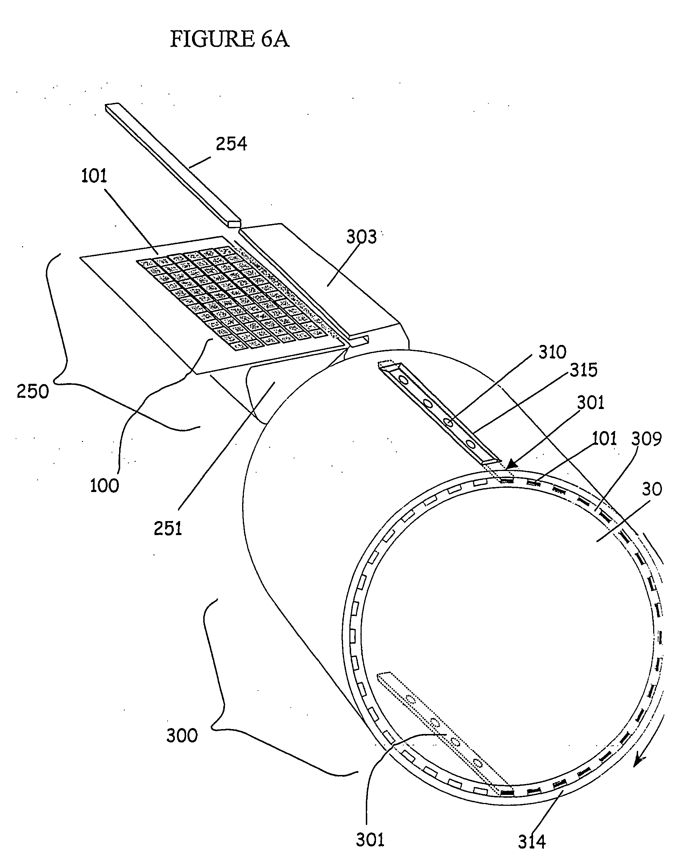

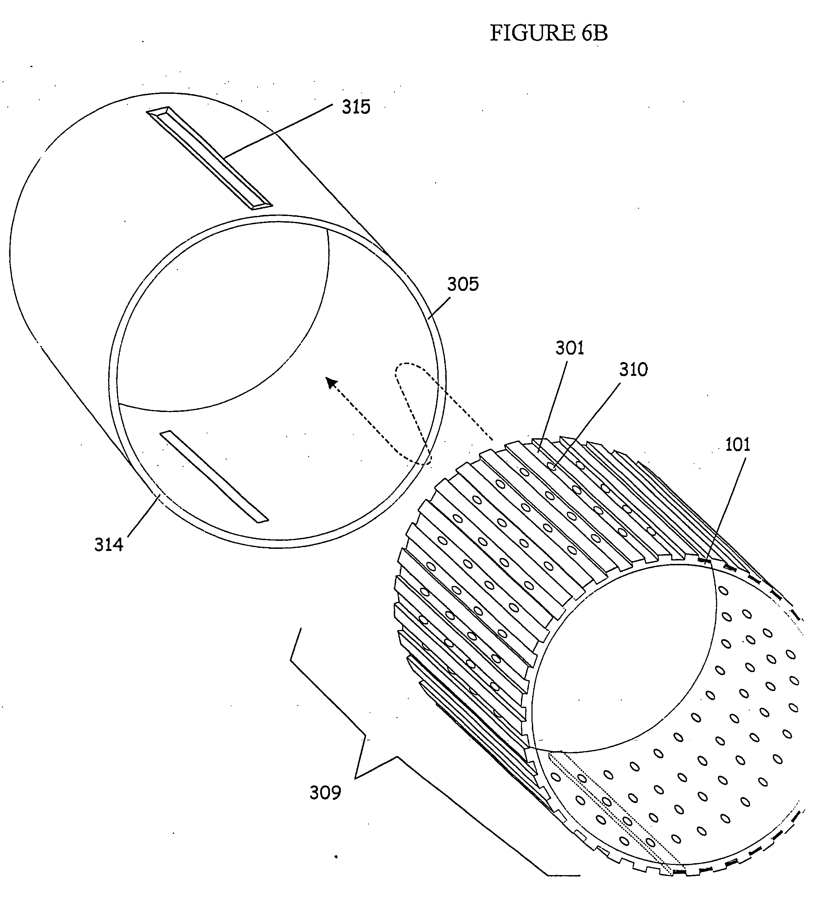

In yet another embodiment similar to that shown in Figure 5D, the chambers 301 are located on the external surface of an inner sleeve 309, as shown in Figure 6A. Sleeve 309 comprises a series of vacuum ports 310, which are used to selectively attract and retain linear chip aggregations 301. Outer sleeve 314 is stationary, as is core cylinder 308. Rotating inner sleeve 309 further includes grooves forming chambers 301. Outer sleeve 314 is fitted with a slot 315 for insertion, and optionally removal of linear chip aggregations 101. Chambers 301 are connected to core cylinder 308 through ports 310 that are in communication with vacuum passages 311 and pressure passages 312, as shown in Figure 5D. Figure 6B is an exploded isometric view of a toothed inner sleeve 309 relative to outer sleeve 314.

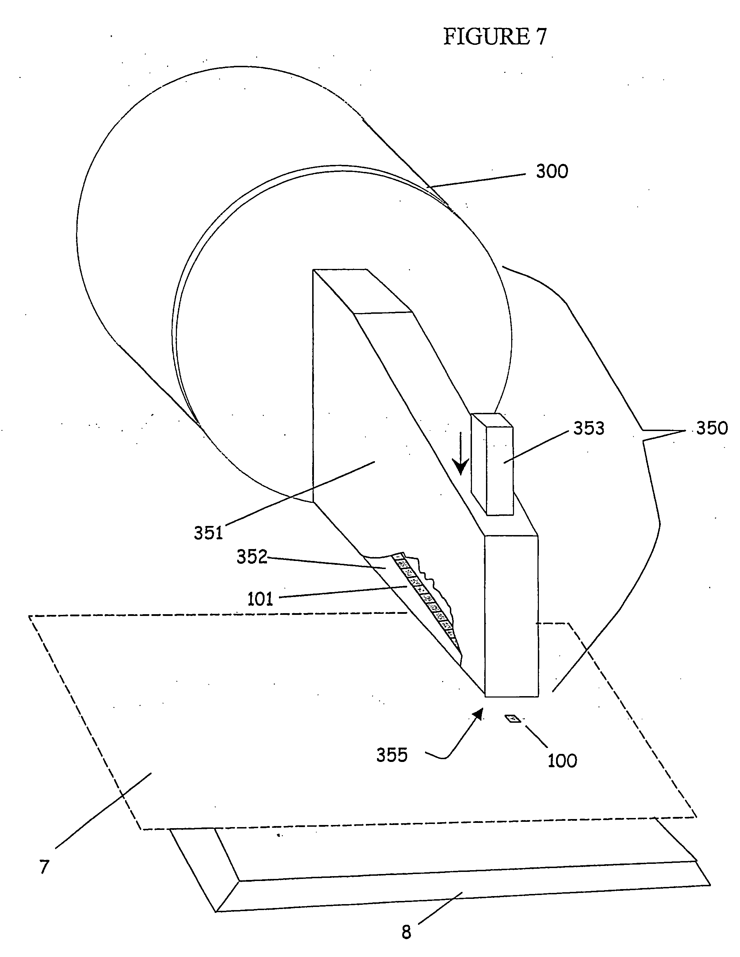

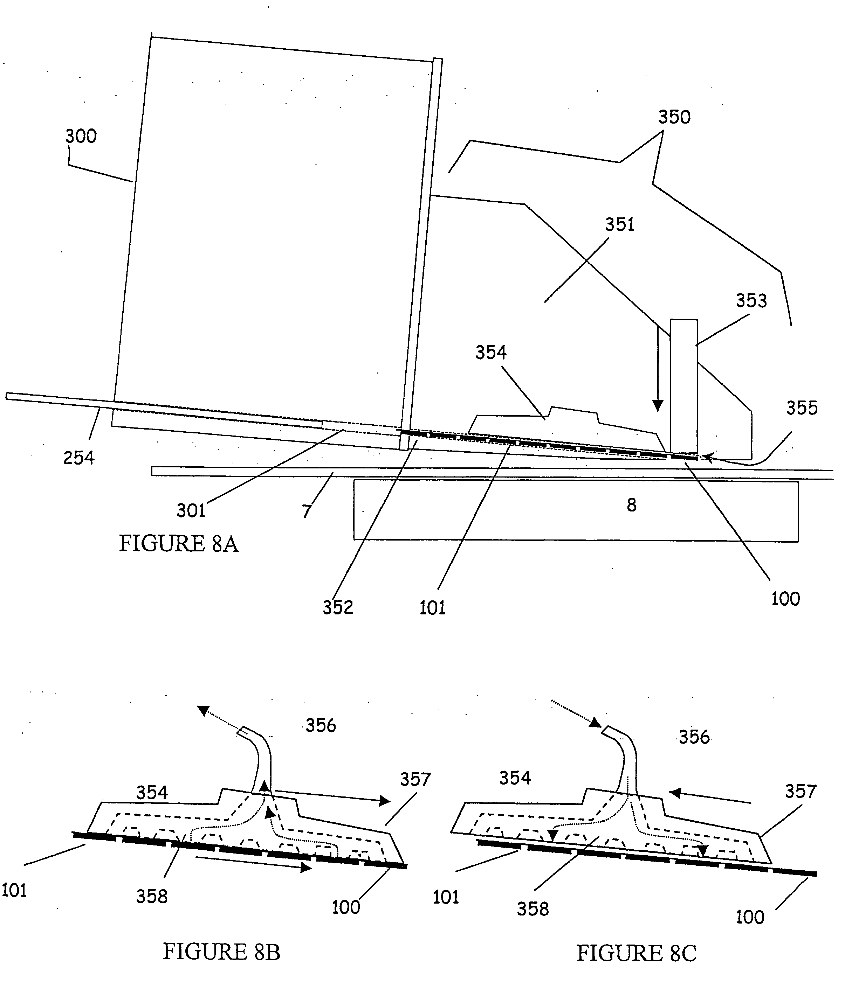

The flat or rotary magazine may be connected to a dispensing device 350, as shown in Figures 7 and 8A, which separates individual die from each linear chip aggregation and places them according to the desired subsequent processing step. Dispensing device 350 comprises a housing 351, which sheathes a transfer support 352 for the moving linear chip aggregation 101, and a tamping means 353, which applies downward pressure to the top surface of chip aggregation 101 to separate it and move it through a dispensing opening 355 onto the desired substrate 7. Device 350 additionally includes a vacuum device 354, which, in cooperation with transfer support 352, attaches and releases chip aggregation 101 at a series of predetermined positions as it is moved through device 350. In this respect, to move the linear chip aggregation 101 forward, vacuum device 354 exerts negative pressure directly over the transfer support 352, generating a suction action that attachably removes and suspends chip aggregation 101. Device 354 is then moved forward one position such that one die is extended directly beneath tamping means 353, at which point the negative pressure is decreased and the chip aggregation 101 is thereby released. The tamping means 353 is then lowered over the single die 100 and pressure applied to sever it from the chip aggregation 101,after which it is released through dispensing opening 355. After release of the die 100, vacuum device 354 is moved backward one or more positions, as necessary, to reload and reposition the chip aggregation 101 for subsequent dispensing. The positioning of device 354 may be determined by the use of sensors or other conventional detecting devices. Device 350 may be used in conjunction with a support 8, as previously described, which provides additional support to a substrate 7, as it is moved in relation to the dispensing opening 355. As linear chip aggregation 101 is used up, additional linear chip aggregations are loaded into dispensing device 350 from rotary magazine 300 by the action of tamping device 254. It should be noted that tamping device 254 may conform to different shapes and dimensions in the various embodiments of the invention.

Figures 8B and 8C show operation of the vacuum device 354, which is composed of an inlet/outlet port 356, housing 357, and ports 358. Ports 358 are alternately evacuated to produce a vacuum that attaches linear chip aggregation 101, or are pressurized with a suitable pressurizing medium to detach the linear chip aggregation 101.

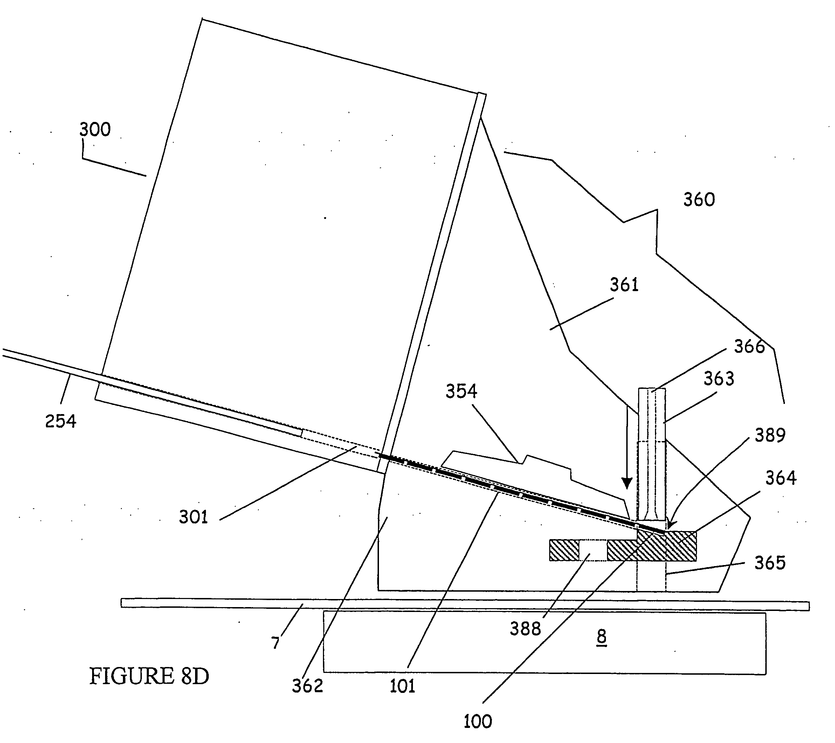

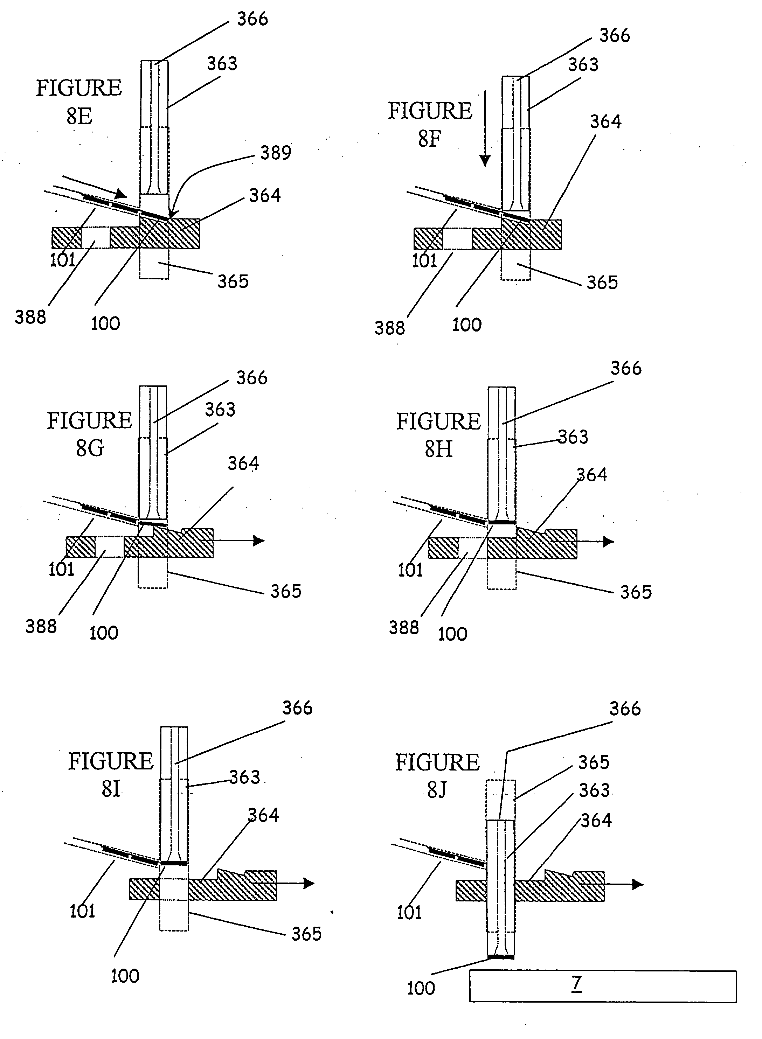

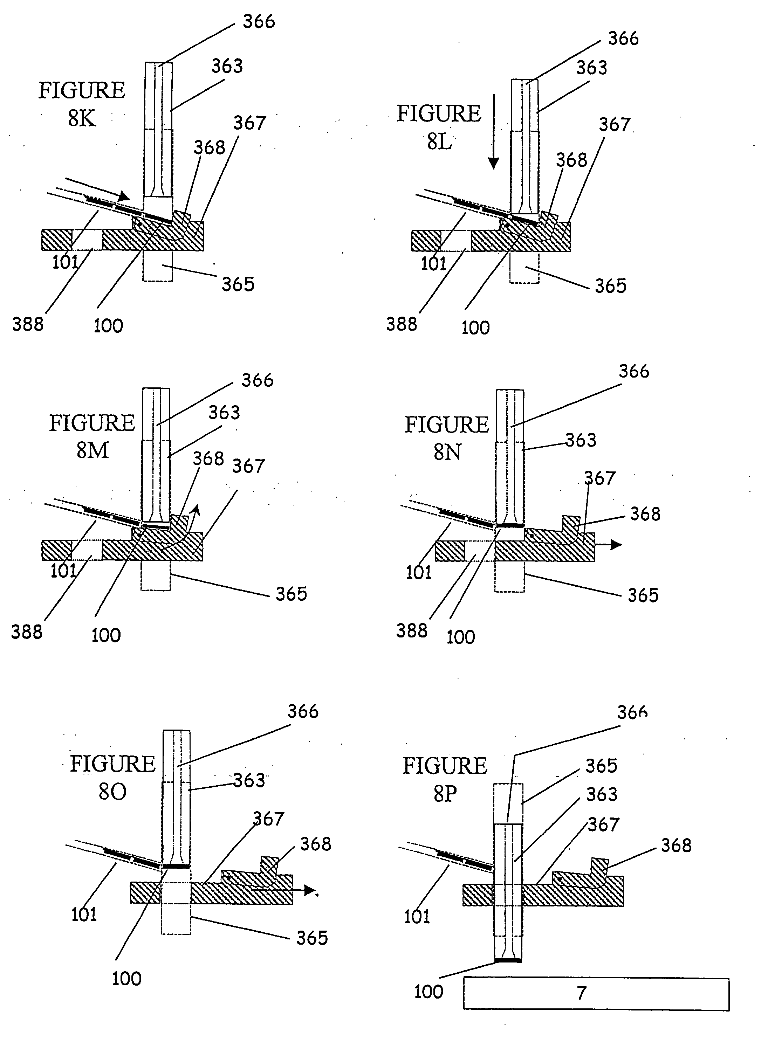

Figure 8D reflects an alternate dispensing device 360 which comprises a housing 361, a transfer support 362, a tamping means 363, a shutter device 364, and a dispensing opening 365. The shutter 364 prevents the last few chips 100 in a linear chip aggregation 101 from falling through dispensing opening 365 prematurely. The transfer support 362 is thick enough in cross section to permit inclusion of devices as wheel, belts, etc (not shown) internally for helping to move the linear chip aggregation 101 through the dispensing device. In particular the thicker transfer support 362 will allow the use of a vacuum device 354 above the linear chip aggregation (as shown), or below the linear chip aggregation (not shown), or as a pair of similar and corresponding devices located above and below the linear chip aggregation (not shown).

As shown in Figure 8E, the linear chip aggregation 101 moves forward at the start of a processing cycle, until the forward edge of the first chip 100 comes into contact with a stop edge 389 on shutter device 364. Figure 8F shows how the tamping means 363 is lowered with light pressure, typically less than the amount that would break the chip 100 loose from linear chip aggregation 101, until tamping means 363 comes in contact with chip 100. Meanwhile a vacuum may be pulled through passage 366 within the tamping means 363, to hold the chip 100 once it is broken free of linear chip aggregation 101.

As shown in Figure 8G, the shutter device 364 is moved sideways so that its surface supporting chip 100 lifts the chip out of line with linear chip aggregation 101, until at some point the chip 100 will break free from linear chip aggregation 101. The top surface of the shutter device 364 may be coated with an appropriate material such as Teflon® or other substance to prevent scratching the electronics on chip 100. Figure 8H shows how the shutter device 364 continues to move until it is completely clear of the separated chip 100, which is now held on the end of tamping means 363, by a vacuum applied through passage 366. At the same time an opening 388 in the shutter device 364 is moved toward the opening 365 in the dispensing device.

As shown in Figure 81, the shutter device 364 is further moved until the opening 388 in the shutter device 364 lines up with the opening 365 in the dispensing device. Finally Figure 8J shows how the tamping means 363 lowers the chip 100 down through openings 388 and 365 to place the chip 100 onto the substrate 7. Once the chip 100 is in contact with the substrate, it may be released by removing the vacuum in passage 366.

Figures 8K through 8P show the operation of another embodiment of a dispensing device including a rotating member. The rotating member may be an element of a shutter, for example, or the entire shutter itself may be capable of rotation. In the embodiment shown, shutter 367 is equipped with a breaking arm 368. Instead of the shutter 367 sliding sideways to break the chip 100 free from linear chip aggregation 101, the breaking arm 368 pivots upwards to break the chip 100 free from linear chip aggregation 101. This may result in less frictional force on the chip surface.

As shown in Figure 8K, the linear chip aggregation 101 moves forward at the start of a cycle, until the forward edge of the first chip 100 is stopped by contact with breaking arm 368 on shutter device 367. Figure 8L shows how the tamping means 363 is lowered with light pressure, typically less than the amount that would break the chip 100 loose from linear chip aggregation 101, until tamping means 363 comes in contact with chip 100. Meanwhile a vacuum may be pulled through passage 366 within the tamping means 363, to hold the chip 100 once it is broken free of linear chip aggregation 101.

As shown in Figure 8M, the breaking arm 368 is rotated or tilted upwards so that its surface supporting chip 100 lifts the chip out of line with linear chip aggregation 101, until at some point the chip 100 will break free from linear chip aggregation 101. The top surface of the breaking arm 368 may be coated with an appropriate material such as Teflon® or other substance to prevent scratching the electronics on chip 100. Figure 8N shows how the shutter device 367 continues to move until it is completely clear of the separated chip 100, which is now held on the end of tamping means 363, by a vacuum applied through passage 366. At the same time an opening 388 in the shutter device 367 is moved toward the opening 365 in the dispensing device.

Figure 80 shows how the shutter device 367 after it has further moved until the opening 388 in the shutter device 367 lines up with the opening 365 in the dispensing device. Finally, Figure 8P shows how the tamping means 363 lowers the chip 100 down through openings 388 and 365 to place the chip 100 onto the substrate 7. Once the chip 100 is in contact with the substrate, it may be released by removing the vacuum in passage 366.

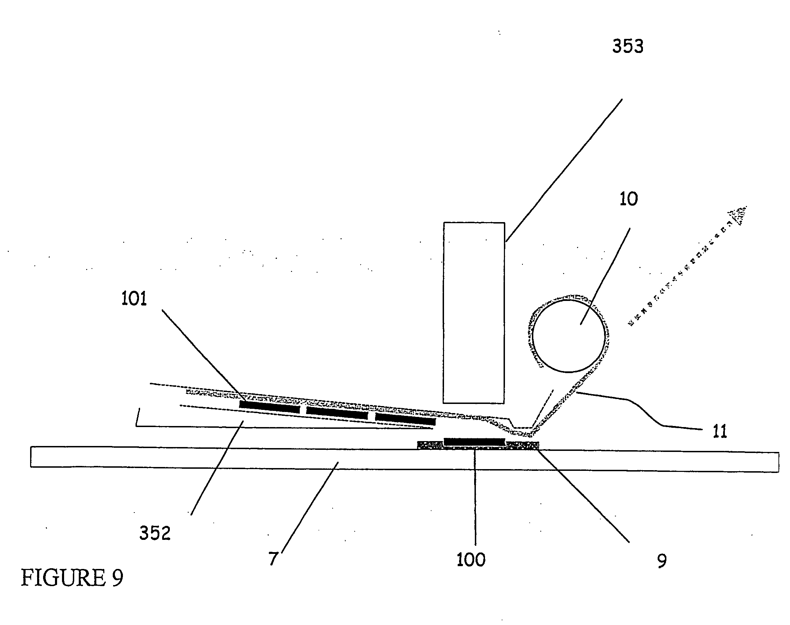

A continuous die placement process is shown in Figure 9. By such a process, an optional carrier adhesive tape or film having one or more linear chip aggregations superimposed thereon may be moved in relation to the previously described dispensing device 350 (not shown), and single dice severed and deposited onto a substrate. As shown, linear chip aggregation 101, which is mounted top face down on an adhesive carrier film 11, is moved beneath tamping device 353. If the adhesive carrier is to be removed, it may be removed via a take-up winder 10. Use of an adhesive carrier film is not essential, however, to the practice of the invention. As shown, a receptor substrate 7 additionally comprising a localized conductive tape area 9 is positioned beneath the carrier film 11. The downward tamping action of the device 353 dislodges die 100 from the carrier 11 and pushes it downward to adhesively contact the localized adhesive area 9 on moving substrate 7. If the chip has capacitive contacts, conductive area 9 may be replaced by a non-conductive type of adhesive applied to substrate 7 before chip 100 is attached.

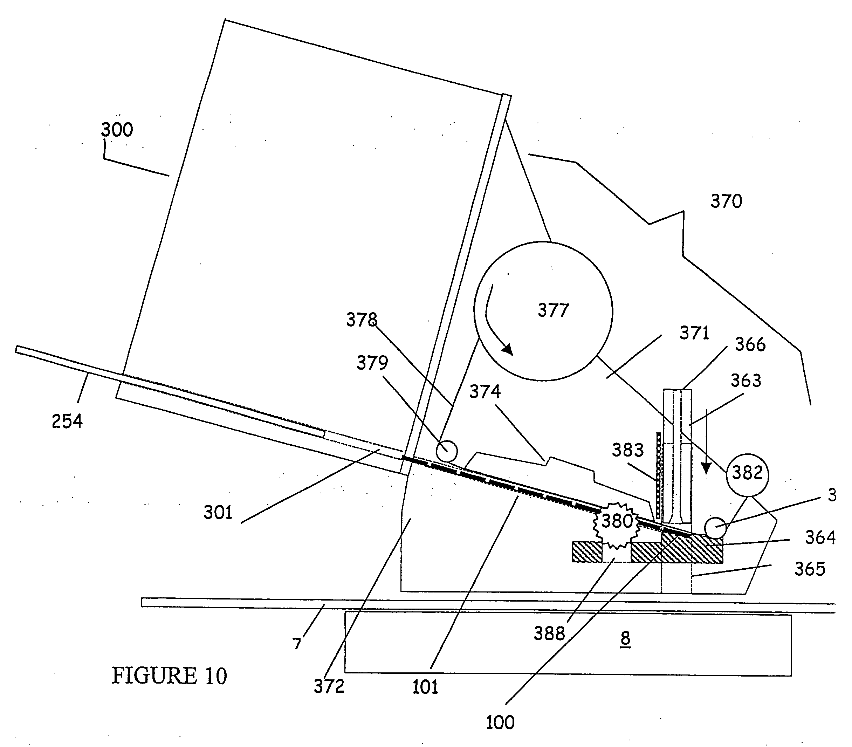

According to Figure 10, an alternative dispensing device 370 comprises housing 371, transfer support 372, tamping means 363 with vacuum passage 366, vacuum /thermal device 374, shutter 364, and openings 365 and 388. Furthermore there is provided a supply roll 377 of a conductive tape 378. The tape 378 travels around first capstan 379, and then under the vacuum device 374 while still being over the linear chip aggregation 101, which in this embodiment is positioned with the circuitry side of the chips facing upwards. Tape 378 travels forward through the dispensing device 370, and contacts a pair of side-cutting blades 380. These blades 380 separate side strips of the tape, which continue under second capstan 381, and onto windup roll 382. It should be realized that some or all parts of the mechanism for applying the tape 378 (elements 377, 379, 381, 382) could be located below the linear chip aggregation 101, instead of above the linear chip aggregation as shown. A crosscutting blade 383 is used to cut the tape holding chip 100 to linear chip aggregation 101.

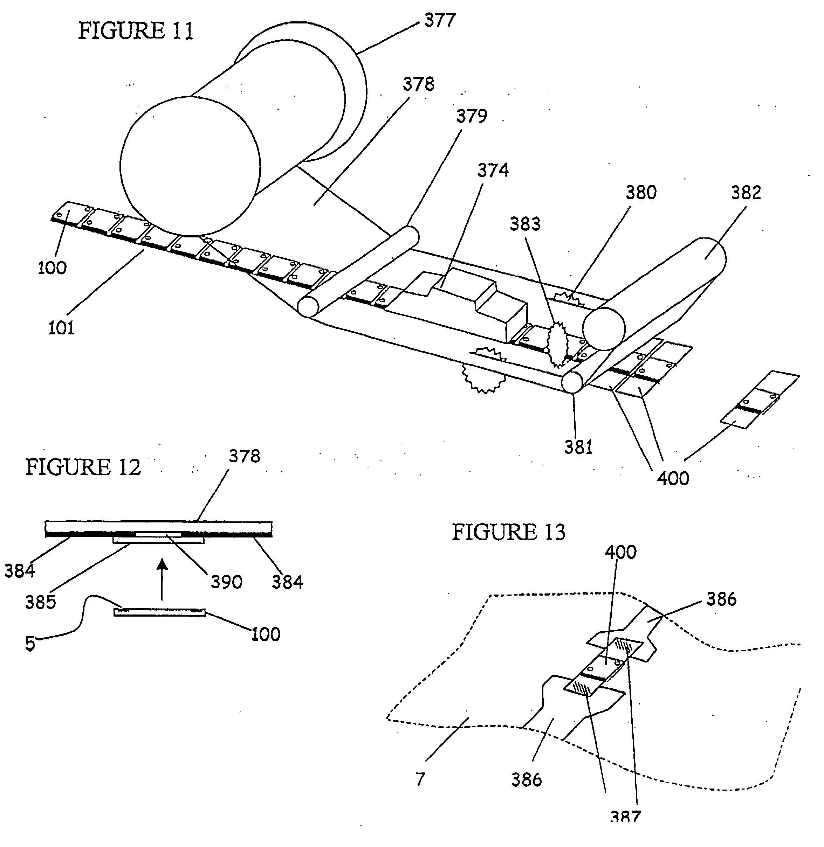

Figure 11 shows an isometric view of the movement of the tape 378, which is provided from supply roll 377. For clarity the tape 378 is drawn as if it were transparent, however this is an optional feature. Figure 12 shows a cross section of the tape 378, drawn in relation to a chip 100 that is shown below the tape 378. Chip 100 includes electrical contact areas 5. The tape 378 includes conductive areas 384 on each side of one face, separated by a non-conductive area 390 located approximately in the center area of the tape. Bridging the non-conductive area and wide enough to slightly overlap both conductive areas 384 is a strip 385 of anisotropic conducting film (ACF) that may be supplied from the supply roll 377, or another supply means (not shown). This material provides an anisotropic conductive center region, which completes the circuit to the chip contacts. The ACF material may be positioned off-center or over the entire surface of the tape. Alternately, the conducting material may be an anisotropic conductive paste applied to the tape 378, or to the linear chip aggregation 101, at any point before joining the tape 378 to the linear chip aggregation 101.

As the tape 378 travels through the chip dispensing mechanism 370, the first capstan 379 and second capstan 381 guide the tape 378 into a path parallel to and coming into contact with the surface of the linear chip aggregation 101.

When the tape 378 and linear chip aggregation 101 have contacted, the joined pair eventually move under the vacuum/thermal device 374, which is similar to the vacuum device 354 described earlier. The vacuum/thermal device 374 helps to move the linear chip aggregation 101 through the dispensing device 370. The vacuum/thermal device is also equipped with local heating to heat the anisotropic conductive film 385 and the linear, chip aggregation 101, while at the same time keeping them joined under pressure, so as to cure the anisotropic conductive film 385 and make an electrical and physical contact between the contacts 5 on chip 100 and the conducting areas 384 on the tape 378. Vacuum/thermal device 374 is preferably long enough to cover several chips, and thus, as moves forward with the linear chip aggregation 101, it remains in thermal and pressure contact long enough to cure the anisotropic conductive film 385. Accordingly, it is unnecessary to stop the substrate web 7 later for thermal/pressure curing of the anisotropic conductive film 385. Additionally, there may be fixed or movable devices (not shown) underneath the linear chip aggregation, to cooperate with vacuum/thermal device 374 and provide the pressure for curing the adhesive, and the forward motion for moving the linear chip aggregation.

As the joined tape 378 and linear chip aggregation 101 move forward through the dispensing device 370, they eventually contact a pair of side cutting blades 380, which trim any excess tape in strips away from the sides of linear chip aggregation 101. The blades are shown in Figure 11 as serrated disks, but other types of blades or thermal or laser devices (not shown) may also be used. The excess side tape strips are then pulled under second capstan 381, and onto take-up roll 382. These excess side tape strips are optionally formed since the tape may vary in width, but where present, they provide a traction means to help pull the tape 378 and the linear chip aggregation 101 through the dispensing device 370.

Just before the linear chip aggregation 101 reaches at the dispensing opening, another blade 383 (or other cutting means) cuts crosswise through the tape 378, so that after a single chip 100 is broken loose from the linear chip aggregation 101, it will be attached to and supported by a strip of tape 378, forming tape interposer 400. As shown in Figure 13, the tape interposer 400 carrying the chip 100 and the conductive areas 384 may then be applied to the poles 386 of an antenna stamped, etched, printed, or otherwise provided on the substrate7. To adhere it to the substrate 7, the tape interposer 400 may have an adhesive layer provided with the tape 378, or adhesive may be applied by other means such as a coating on the substrate 7 prior to the application interposer 400. The chip 100 is connected by electrical contacts 5 through the anisotropic conductive film 385 to the conductive areas 384, and is connected to the antenna poles 386 by means such as mechanical crimping 387 to complete the antenna-chip circuit. It may be desirable to apply an overprinted varnish, another tape, or other means to protect the circuit.

The apparatus and process of the present invention therefore provide a rapid, efficient and cost-effective method of processing diced semiconductor materials. The various embodiments of the inventive concept find application in any process requiring the precise placement of small and sensitive devices that require minimal deformation or other damage, clean handling, and efficient yet precise placement on a receiving substrate. Because of such improved efficiency, products incorporating semiconductor devices such as MEMS, photonic cells, integrated circuits and other similar devices may be constructed cheaply for large-scale use. Useful applications of such cheaply produced materials include, but are not limited to, manufacture of radio frequency identification (RFID) devices such as tags for inventory control or supply chain management.

## Claims

1. A method of processing semiconductor chips for integrated circuit, MEMS or photonic device manufacture comprising:
a) at least partly severing a wafer of semiconductor material in at least one dimension to provide at least one parting line;
b) completely severing the wafer in a dimension perpendicular to the at least one parting line to form one or more linear chip aggregations composed of partially joined individual chips, each linear chip aggregation being separated by one or more severed edges of the individual chips;
c) aligning the one or more linear chip aggregations with reception sites on a substrate;
d) dispensing individual chips from the one or more linear chip aggregations onto the reception sites by severing a single chip from each linear chip aggregation and contacting it with the surface of the substrate while simultaneously preserving its linear orientation and controlling its alignment on the surface of the substrate.

2. The method of claim 1, in which the step of at least partly severing the wafer is performed by sawing through less than the entire thickness of the wafer.

3. The method of claim 1 or claim 2 in which the semiconductor wafer is backed by an adhesive material and the step of at least partly severing the wafer does not sever the adhesive material.

4. The method of and of claims 1 to 3 in which the dispensing of individual chips includes extending a single chip over a reception site and perpendicularly applying pressure from a tamping means to the bottom face of the chip to sever it from the linear chip aggregation and deposit it on the reception site.

5. The method of any of claims 1 to 3 in which the dispensing of individual chips includes extending a single chip over a reception site and severing the single chip from the linear chip aggregation by applying force from a sliding member.

6. The method of any of claims 1 to 3 in which the dispensing of individual chips includes extending a single chip over a reception site and dispensing the single chip from the linear chip aggregation by applying force from a device having a rotating member.

7. The method of any of claims 1 to 3 in which the dispensing of individual chips includes extending a single chip over a reception site and severing the single chip from the linear chip aggregation using a shutter device.

8. The method of any of the preceding claims in which the dispensing of individual chips includes providing within the dispensing device a tape material to assist in fastening the chip to the substrate.

9. The method of claim 8 in which the tape material comprises conductive side areas for bonding to electrically active areas of the substrate, a non-conductive area between the conductive side areas, and an anisotropic conductive region for bonding to electrically active areas of the chip.

10. The method of any of the preceding claims wherein the method of dispensing individual chips is synchronized using a sensor to detect the position of the target.

11. A method of manufacturing an integrated circuit device comprising:
a) preparing a receiving substrate;
b) separating a wafer of semiconductor material into one or more linear chip aggregations;
c) aligning the one or more linear chip aggregations with reception sites on a receiving substrate; and
d) severing a single chip from each one or more linear chip aggregation and contacting it with the reception site while simultaneously preserving the linear orientation and controlling the alignment of said chip; and
e) disposing the chip onto one or more devices selected from antennae, contacts, circuits or electrodes on the receiving substrate.

12. The method of claim 11, wherein the substrate includes a circuit.

13. The method of claim 12, wherein the chip is contacted with the circuit to effect closure thereof.

14. The method of claim 12 or claim 13, wherein the circuit is an antenna loop.

15. A stapler apparatus for dispensing diced semiconductor materials on a substrate, comprising:
a) one or more chambers for receiving and holding one or more linear chip aggregations; and
b) a dispensing device that releases individual chips from the one or more linear chip aggregations held within said chambers onto reception sites on a substrate.

16. The stapler apparatus of claim 15 where the dispensing device further includes a shutter means.

17. The apparatus of claim 15 or claim 16 where the dispensing device further includes a slidable member for separating individual chips from the one or more linear chip aggregations.

18. The apparatus of claim 15 where the dispensing device further includes a rotatable member for separating individual chips from the one or more linear chip aggregations.

19. The apparatus of any of claims 15 to 18 further comprising one or more first tamping means for loading the linear chip aggregations into the chambers.

20. The apparatus of any of claims 15 to 19 further comprising one or more second tamping means for dispensing chips from the dispensing device.

21. A rotary magazine for receiving and dispensing linear aggregations of diced semiconductor chips comprising at least one sleeve surrounding a core cylinder; and a series of chambers on the interior or exterior of the at least one sleeve, each chamber accommodating one or a series of linear aggregations of semiconductor chips therein.

22. The rotary magazine of claim 21 further including one or more ports for vacuum or pressure application to the chambers.

23. A flat magazine for receiving and dispensing linear aggregations of diced semiconductor chips comprising a chamber having a loading end and a dispensing end, the loading end being in communicable relation to a first tamping means, and the dispensing end being in communicable relation to a second tamping means.
